# EUROPEAN PATENT SPECIFICATION

(11) **EP 3 979 503 B1**
(45) Date of publication and mention of the grant of the patent: **25.11.2026**
(21) Application number: 21200115.0
(22) Date of filing: 30.09.2021
(51) Int. Cl.: H03M 1/10, H03M 1/56

(54) **SELF-CALIBRATING SINGLE SLOPE ANALOG-TO-DIGITAL CONVERTER**
SELBSTKALIBRIERENDER SINGLE-SLOPE-ANALOG-DIGITAL-WANDLER
CONVERTISSEUR ANALOGIQUE-NUMÉRIQUE À PENTE UNIQUE ET À AUTO-ÉTALONNAGE

(30) Priority: 30.09.2020 US 202017038329
(43) Date of publication of application: 06.04.2022
(73) Proprietor: NXP B.V., 5656 AG Eindhoven (NL)
(72) Inventor: STRIJKER, Joan Wichard, 5656AG Eindhoven (NL)
(74) Representative: Schwarzweller, Thomas

(56) References cited:
- WO-A1-81/01489
- US-A- 3 750 142
- US-A1- 2007 046 513
- US-A1- 2007 046 802
- US-A1- 2009 174 442
- US-A1- 2010 231 233
- US-A1- 2012 194 367
- AKYUREK FATIH ET AL: "Digital output ROIC with single slope ADC for cooled infrared applications", MICROSYSTEM TECHNOLOGIES, BERLIN, DE, vol. 23, no. 4, 10 May 2016 (2016-05-10), pages 1091 - 1099, XP036179496, ISSN: 0946-7076, [retrieved on 20160510], DOI: 10.1007/S00542-016-2963-7

## Description

### TECHNICAL FIELD

Various exemplary embodiments disclosed herein relate generally to a self-calibrating single slope analog-to-digital converter (ADC).

### BACKGROUND

Single slope analog-to-digital converters (ADC) are widely used in a variety of different electronic systems because of their simplicity. The accuracy of the conversion may be improved by compensation and calibration.

United States patent application, publication number US 2007/046802 discloses an image sensor using an auto-calibrated ramp signal for improved image quality and a driving method thereof. The main circuit includes an ADC which incorporates a ramp generator. A second ADC is used to calibrate the ramp signal generator.

The publication AKYUREK FATIH ET AL: "Digital output ROIC with single slope ADC for cooled infrared applications",MICROSYSTEM TECHNOLOGIES, BERLIN, DE, vol. 23, no. 4, 10 May 2016 (2016-05-10), pages 1091-1099, describes a digital output ROIC employing a single slope ADC with an auto calibrated ramp generator.

The patent application US 2009/174442 A1 relates to a CMOS image sensor comprising an ADC configured to perform correlated double sampling and convert an image signal using the slope-changed corrected ramp signal.

The patent application US 2012/194367 A1 concerns a design and calibration of a continuous ramp generator for CMOS image sensors using single-ramp ADCs.

The patent application US 2007/046513 A1 presents an image sensor using a single slope ADC and a method for auto-calibrating the slope of a ramp signal in an analog manner.

The patent application WO 81/01489 A1 discloses a single slope ADC in which a DAC trims the discharge current of a capacitor during a calibration phase.

The patent application US 3 750 142 A provides an ADC incorporating a closed-loop feedback system enabling periodic self-calibration of the ramp signal.

### SUMMARY

According to the disclosure, we provide an ADC and a method as defined in the claims. Other embodiments provided in the summary are for understanding and context. A summary of various exemplary embodiments is presented below. Some simplifications and omissions may be made in the following summary, which is intended to highlight and introduce some aspects of the various exemplary embodiments, but not to limit the scope of the invention. Detailed descriptions of an exemplary embodiment adequate to allow those of ordinary skill in the art to make and use the inventive concepts will follow in later sections.

Various embodiments relate to a single slope analog to digital converter (ADC), including: a voltage slope generator configured to generate a voltage slope based upon a fixed current and variable current; an analog comparator configured to compare a voltage to a voltage output from the voltage slope generator; a first register configured to store a first count based upon a reference voltage being input into the analog comparator; a second register configured to store a second count based upon an input voltage being input into the analog comparator, wherein the input voltage is the voltage to be converted to a digital value by the ADC; and a digital to analog converter (DAC) configured to produce a slope trim signal based upon the voltage slope output by the voltage slope generator, the first count, and a count target associated with the voltage reference, wherein the variable current in the voltage slope generator is based upon the slope trim signal.

Various embodiments are described, wherein the voltage slope generator includes: a fixed current source configured to generate the fixed current; and a voltage to current (VI) converter configured to convert the slope trim signal into the variable current, wherein the fixed current and the variable current are combined to produce a slope current used to generate the voltage slope.

Various embodiments are described, wherein the voltage slope generator includes voltage to current (VI) converter configured to convert the slope trim signal into the variable current, wherein VI converter produces the fixed current and combines the fixed current with the variable current to produce a slope current used to generate the voltage slope.

Various embodiments are described, wherein the DAC further includes: a control regulator configured to receive a difference between the first count and a count target; a digital comparator configured to compare an output of the control regulator and a counter; and a sample and hold circuit configured to sample the voltage slope based upon an output of the comparator, wherein the output of the sample and hold circuit is the slope trim.

Various embodiments are described, wherein the control regulator is a digital integrator.

Various embodiments are described, wherein the control regulator is a digital proportional-integral-derivative regulator.

Various embodiments are described, wherein the control regulator is a digital proportional-integral regulator.

Various embodiments are described, wherein the sample and hold circuit includes a switch controlled by the output of the digital comparator and a capacitor.

Various embodiments are described, further comprising an analog buffer connected between the output of the voltage slope generator and the sample and hold circuit.

Various embodiments are described, further including: a switch with an output connected to the analog comparator and a first input configured to receive the reference voltage and a second input configured to receive the input voltage; and a controller configured to actuate the switch between the first input and the second input.

Various embodiments are described, wherein the controller is further configured to determine when the output of the DAC has settled.

Various embodiments are described, wherein the voltage slope generator further includes a slope switch and the wherein the controller is further configured to control the slope switch in order to generate the voltage slope.

Various embodiments are described, wherein the second count indicates a digital value corresponding to the input voltage.

Further various embodiments relate to a method for converting an analog voltage to a digital value using a single slope analog to digital converter (ADC), including: generating a voltage slope based upon a fixed current and variable current; comparing the reference voltage to the voltage output from the generated voltage slope and storing a first count based upon the reference voltage; comparing an input voltage to the voltage output from the generated voltage slope and storing a second count based upon the input voltage; producing a slope trim signal based upon the voltage slope, the first count, and a count target associated with the voltage reference, wherein the slope trim signal is used to generate the variable current.

Various embodiments are described, wherein generating a voltage slope includes: generating the fixed current; voltage converting the slope trim signal into the variable current; combining the fixed current and the variable current to produce a slope current; and converting the slope current into the voltage slope.

Various embodiments are described, wherein the wherein generating a voltage slope includes actuating a slope switch to generate the voltage slope.

Various embodiments are described, wherein producing a slope trim signal further includes: integrating a difference between the first count and a count target; comparing an integrated difference to a clock value; and sampling and holding the buffered generated voltage slope to produce a slope trim signal when the clock value is equal to the digital input value.

Various embodiments are described, wherein sampling and holding the buffered generated voltage slope includes actuating a switch based upon a comparison of the reference voltage to the voltage output and applying the output voltage of the switch to a capacitor.

Various embodiments are described, further comprising buffering the voltage slope.

Various embodiments are described, further including: applying the reference voltage to the comparator until the slope trim signal has settled; and applying the input voltage to the comparator.

Various embodiments are described, wherein the second count indicates a digital value corresponding to the input voltage.

### BRIEF DESCRIPTION OF THE DRAWINGS

In order to better understand various exemplary embodiments, reference is made to the accompanying drawings, wherein:
FIG. 1 illustrates a basic single slope ADC;
FIG. 2 illustrates an embodiment of a self-calibrating single slope ADC; and
FIG. 3 includes plots that illustrate how the operation of the ADC settles and self-calibrates based upon a simulation of the ADC.

To facilitate understanding, identical reference numerals have been used to designate elements having substantially the same or similar structure and/or substantially the same or similar function.

### DETAILED DESCRIPTION

The description and drawings illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be for pedagogical purposes to aid the reader in understanding the principles of the invention and the concepts contributed by the inventor(s) to furthering the art and are to be construed as being without limitation to such specifically recited examples and conditions. Additionally, the term, "or," as used herein, refers to a non-exclusive or (*i.e.,* and/or), unless otherwise indicated (*e.g.,* "or else" or "or in the alternative"). Also, the various embodiments described herein are not necessarily mutually exclusive, as some embodiments can be combined with one or more other embodiments to form new embodiments.

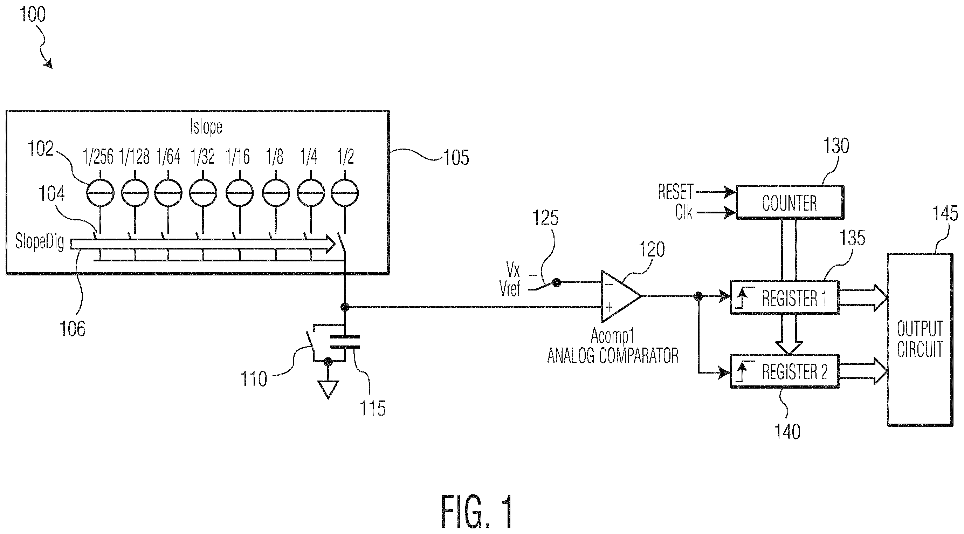

ADCs may be implemented using a voltage slope. FIG. 1 illustrates a basic single slope ADC 100. A voltage slope is created with a current source 105 producing a current Islope and capacitor Cslope 115. The dv/dt of the voltage slope is Islope/Cslope. The current source 105 may be a digitally controlled current source. The current source may include a plurality of different current sources 102. In this specific example eight different current sources 102 are shown with values of I/256, I/128, I/64, I/32, I/16, I/8, I/4, and I/2. The current source 105 includes a plurality of switches 104 where each switch is connected to one of the current sources 102. A control signal 106 will control each of the plurality of switches 104 in order to achieve a desired current value.

The voltage slope is started by opening slope switch 110. As soon as the voltage slope starts, a counter 130, producing a count, is also started by removing a Reset signal input into the counter 130. The counter also receives a clock signal Clk that cause the counter to increment with each clock cycle.

For calibration, a reference voltage Vref (as selected by a switch 125) and the voltage slope are connected to an analog comparator 120. When the voltage slope reaches the reference voltage Vref, the comparator 120 trips causing the current counter value to be stored in first register (Reg1) 135. This count Ref1 is indicative of the analog voltage value Vref and provides a calibration basis.

To convert an analog voltage, Vx, to a digital value, the analog voltage Vx is connected to the analog comparator 120. Switch 125 is used to connect either the reference voltage Vref or the analog voltage Vx to the comparator 120. As soon as the voltage slope starts, a counter 130, producing a count Count, is also started by removing a Reset signal input into the counter 130. Again, when the voltage slope reaches the analog voltage Vx, the comparator 120 trips and the counter value is stored in a second register (Reg2) 140 indicative of the analog voltage value Vx.

If the offset and the delay of the comparator are neglected, Reg 1 135 and Reg2 140 will store the values: $Reg 1 = Fclk \frac{Vref}{dvdt} ; and$ (1) $Reg 2 = Fclk \frac{{V}_{X}}{dvdt} .$ (2) Fclk is the clock frequency used for the counter and dvdt is the voltage slope Islope/Cslope.

The value of Vx may then be calculated as: ${V}_{X} = Reg 2 \frac{Vref}{Reg 1} .$ (3)

By using the reference voltage, the value of the clock frequency and the slope value is not needed for the analog to digital conversion.

In order to simplify the calculation of Vx, the slope current may be adjusted in response to the register value so that dvdt is adjusted such that the register holds the target value after a number of analog to digital cycles. For example, the first register 135 may hold the value (Reg1) 1000 for a reference voltage of 1V.

As the slope was trimmed in the previous step, the second register value Reg2 does not need any calculation to find Vx. In this example where the first register holds the value 1000 for an input voltage of 1V, Vx would be 548mV if Reg2 stored the value 548.

Although the conversion can also be done without a trimmed slope, the value of Vx may be found by calculation using (3), it is advantageous to have direct relation between the register value and voltage when many calculations need to be done and/or computing power is limited.

A limitation of this solution is that the digital current source is increasingly difficult to realize when more bits are required resulting in differential non-linearity (DNL) errors. The current sources need to be made with very high accuracy. For 10 bits, the current source matching requirement would be 0.1%.

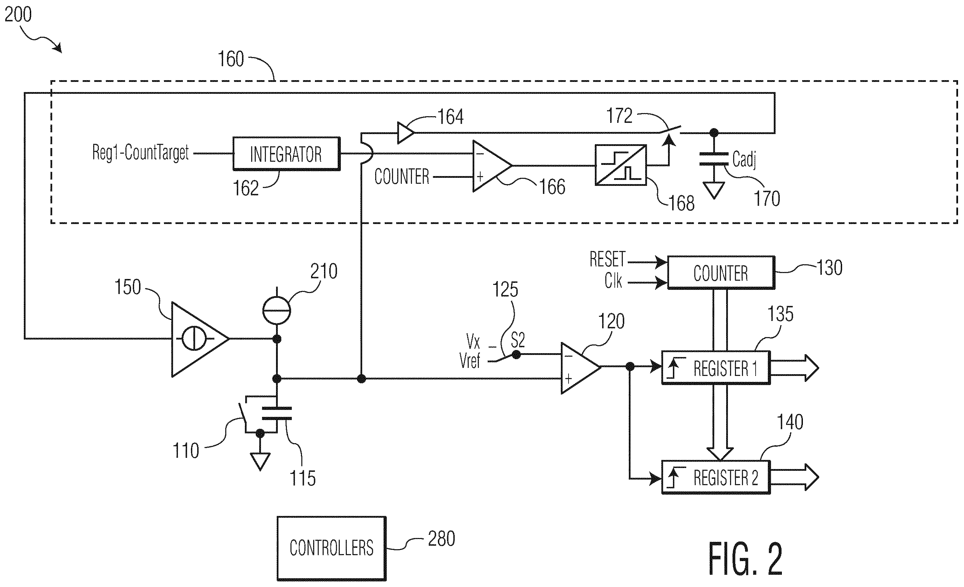

FIG. 2 illustrates an embodiment of a self-calibrating single slope ADC. The ADC 200 is similar to the ADC 100 of FIG. 1, but uses a different structure and method for generating the slope current. The digital adjustable current source 105 is replaced by a fixed current source 210 and a voltage to current (VI) converter 150. The input voltage for the VI converter 150 is created by a digital to analog converter (DAC) 160.

The DAC 160 is a single slope DAC that uses the same slope as the ADC. The DAC 160 includes a digital integrator 162, a digital comparator 166, a pulse circuit 168, a capacitor (Cadj) 170, a sample and hold switch 172, and a buffer 164. The digital integrator 162 sums the error value Reg1 - CountTarget, where CountTarget is the target value for Reg1 in the first register 135 for a specific voltage value, e.g., 1000 when the input voltage is 1V. The output of the digital integrator 162 is connected to a digital comparator 166. The digital comparator 166 trips when the counter value reaches the integrator value. The pulse circuit 168 creates a pulse based upon the edge of the digital comparator 166 output. This output pulse closes the sample and hold switch 172 and samples the voltage slope. For a practical implementation, the voltage slope is buffered by buffer 164 to prevent disturbance of the voltage slope due to the sampling of the voltage slope by the sample and hold switch 172. The sampled voltage slope becomes a trim voltage Vslopetrim that is stored on capacitor Cadj 170.

Because the calibration is in a closed loop (*i.e.,* the error Reg1-CountTarget is summed over time), errors caused by the offset of the buffer 164 or sampling errors in the voltage stored on the capacitor Cadj 170, are compensated.

The current for creating the slope cannot be generated only by the VI converter 150 with a one to one relation of the voltage and the current (*i.e*., Islope=gm*VslopeTrim, with gm the transconductance of the VI converter 150). This would create a chicken and egg problem: because the trim voltage VslopeTrim would have a one to one relation to the slope, and the slope would have a one to one relation to the trim voltage, so no solution would be available.

If the slope current is only partially generated by the VI converter 150 and the other part of the slope current (Ifixed) is generated by a fixed current generator 210, the calibration loop may converge to the solution where Reg1=CountTarget, *i.e.,* by using Islope=Ifixed+gm*VslopeTrim the feedback loop is able to converge on a system state where Reg1=CountTarget.

In another embodiment, the VI converter 150 may also have an offset current at the output or an offset voltage at the input such that there is no one to one relation of the voltage and current. The VI converter 150 then behaves the same as a VI converter with a one to one relation of voltage and current combined with a fixed current source. In this situation the offset current at the output is equal to the fixed current, *i.e.,* Islope=Ivic=Ioffset+gm*Vslopetrim. Thus, such a single VI converter 150 may replace both the VI converter and fixed current generator.

For integrated circuits, uncalibrated errors for internal current sources may be as large as 20%, for example (dependent on the IC process used). If the fixed current source 210 supplies 80% of the current required for the target slope value, the VI converter 150 may supply the other 20%. The calibration loop will converge to the situation where Reg1=CountTarget in several analog to digital and digital to analog cycles.

As soon as Reg1=CountTarget the calibration loop is stabilized and an analog to digital conversion for the Vx voltage can be done. A controller 280 may detect when Reg1=CountTarget, then the switch 125 may be switched to allow the voltage Vx to be converted.

In a typical application the calibration loop is updated after one or more analog to digital conversion cycles of Vx. These updates are required because, for example, the fixed current source value can change with temperature or the voltage on the Cadj capacitor changes due to leakage currents. Also the transconductance of the VI converter 150 may change with temperature. Hence the calibration update may be done periodically based upon predetermined time intervals or every N ADC cycles.

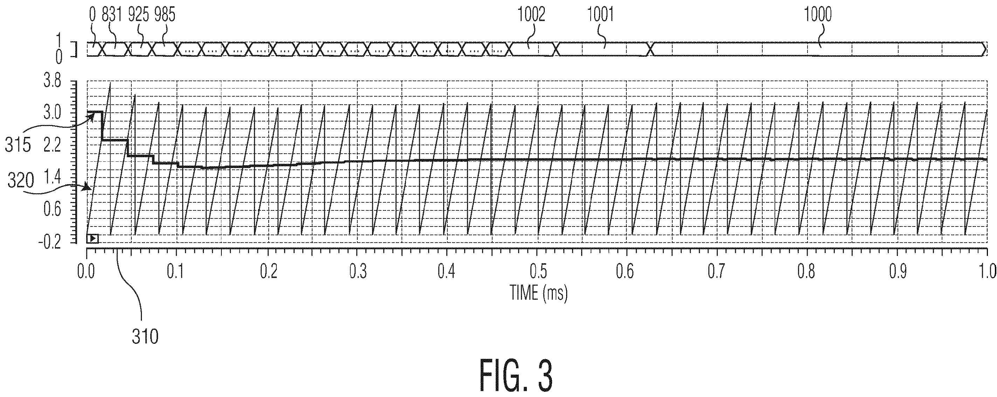

FIG. 3 includes plots that illustrate how the operation of the ADC 200 settles and self-calibrates based upon a simulation of the ADC. The top plot 305 illustrates the value stored in Reg1 over time. In this example, the register target value is 1000.

In the bottom graph the SlopeTrim voltage 315 and the voltage slope 320 are plotted over time. During the first cycles, the SlopeTrim voltage 315 is too high and consequently the voltage slope 320 is too steep and the Reg1 value 305 is too low. The calibration loop adjusts the SlopeTrim voltage by performing a digital to analog conversion cycle. The changed SlopeTrim voltage 315 changes the slope of the voltage slope 320 and consequently the Reg1 value 305. Depending on the ratio of the fixed current output by the fixed current generator 210 and the current output by the VI converter and depending on the integrator settings, after several cycles, the value Reg1 in the first register reaches the target value of 1000.

In an alternative embodiment, for a faster settling time of the calibration loop, the digital integrator can be replaced by a digital proportional-integral-derivative (PID) regulator, digital proportional-integral regulator, or any other suitable digital regulator.

The advantage the ADC disclosed herein over the existing art is that no digital adjustable current source is required. Further, the single slope DAC is used, and because in a single slope DAC the voltage slope is always rising, DNL errors are low. The difficult to design current source of FIG. 1 is replaced by a simple DAC circuit which has no difficult to design requirements. Errors in the calibration loop, *e.g.,* offset in the buffer 164 or in the sample and hold switch 168/capacitor Cadj 170 combination, are compensated for by the integration in the calibration loop.

It should be appreciated by those skilled in the art that any block diagrams herein represent conceptual views of illustrative circuitry embodying the principles of the invention.

Although the various exemplary embodiments have been described in detail with particular reference to certain exemplary aspects thereof, it should be understood that the invention is capable of other embodiments and its details are capable of modifications in various obvious respects. Accordingly, the foregoing disclosure, description, and figures are for illustrative purposes only and do not in any way limit the invention, which is defined only by the claims.

## Claims

1. A self-calibrating single slope analog to digital converter, ADC, (200), comprising:
a voltage slope generator configured to generate, and output, a voltage slope based upon a fixed current and variable current, wherein the fixed current and the variable current are combined to produce a slope current used to generate the voltage slope;
an analog comparator (120) configured to compare a voltage, being either a reference voltage or an input voltage, to a voltage output from the voltage slope generator;
a first register (135) configured to store a first count based upon the reference voltage (Vref) being input into the analog comparator, the first count determined using a counter (130) configured to start counting based on a start of the voltage slope;
a second register (140) configured to store a second count, using the counter (130), based upon the input voltage being input into the analog comparator, wherein the input voltage is the voltage to be converted to a digital value by the ADC; and
a digital to analog converter, DAC, (160) configured to produce a slope trim signal based upon the voltage slope output by the voltage slope generator, the first count, and a count target associated with the voltage reference, wherein the DAC (160) includes a digital integrator (162), a digital comparator (166), a pulse circuit (168), a capacitor (170), a sample and hold switch (172), and a buffer (164), wherein the digital integrator (162) is configured to sum the difference between the first count of the first register and the count target to generate an integrator value, wherein an output of the digital integrator (162) is connected to the digital comparator 166, which is configured to trip when a counter value of the counter (130) reaches the integrator value, and wherein the pulse circuit (168) is configured to create a pulse based upon an edge of the output of the digital comparator (166), wherein the sample and hold switch (172) is configured to close based on the pulse and sample the voltage slope for said producing of the slope trim signal,
wherein the variable current in the voltage slope generator is based upon the slope trim signal.

2. The ADC (200) of claim 1, wherein the voltage slope generator includes:
a fixed current source (210) configured to generate the fixed current; and
a voltage to current, VI, (150) converter configured to convert the slope trim signal into the variable current.

3. The ADC (200) of claim 1, wherein the voltage slope generator includes voltage to current, VI, converter (150) configured to convert the slope trim signal into the variable current,
wherein VI converter (150) produces the fixed current and combines the fixed current with the variable current to produce a slope current used to generate the voltage slope.

4. The ADC (200) of any preceding claim, wherein the buffer (164) is an analog buffer connected between the output of the voltage slope generator and the sample and hold switch.

5. The ADC (200) of any preceding claim, further comprising:
a switch (125) with an output connected to the analog comparator (120) and a first input configured to receive the reference voltage (Vref) and a second input configured to receive the input voltage; and
a controller configured to actuate the switch between the first input and the second input.

6. The ADC (200) of claim 5, wherein the controller is further configured to determine when the output of the DAC (160) has settled.

7. The ADC (200) of claim 5 or 6, wherein the voltage slope generator further includes a slope switch (110) and wherein the controller is further configured to control the slope switch (100) in order to generate the voltage slope.

8. The ADC (200) of any preceding claim, wherein the second count indicates a digital value corresponding to the input voltage.

9. A method for converting an analog voltage to a digital value using a self-calibrating single slope analog to digital converter, ADC, comprising:
generating a voltage slope based upon a fixed current and variable current, wherein the fixed current and the variable current are combined to produce a slope current used to generate the voltage slope;
comparing a reference voltage to the voltage output from the generated voltage slope and storing a first count based upon the reference voltage, the first count determined using a counter (130) configured to start counting based on a start of the voltage slope;
comparing an input voltage to the voltage output from the generated voltage slope and storing a second count based upon the input voltage, said second count determined using the counter (130); and
producing a slope trim signal based upon the voltage slope, the first count, and a count target associated with the voltage reference, wherein producing a slope trim signal further includes: integrating a difference between the first count and a count target to generate an integrated difference; comparing the integrated difference to a clock value indicative of a time from a start of the voltage slope; and sampling and holding a buffered generated voltage slope to produce the slope trim signal when the clock value is equal to the integrated difference;
wherein the slope trim signal is used to generate the variable current.

10. The method of claim 9, wherein generating a voltage slope includes:
generating the fixed current;
voltage converting the slope trim signal into the variable current; and
converting the slope current into the voltage slope.

11. The method of claim 9 or 10, wherein generating a voltage slope includes actuating a slope switch to generate the voltage slope.

## Patentansprüche

1. Selbstkalibrierender Analog-Digital-Wandler (ADC) mit einer einzelnen Flanke (200), der Folgendes umfasst:
einen Spannungsflankengenerator, der dazu ausgelegt ist, eine Spannungsflanke basierend auf einem konstanten Strom und einem variablen Strom zu erzeugen und auszugeben, wobei der konstante Strom und der variable Strom kombiniert werden, um einen Flankenstrom zu erzeugen, der zum Erzeugen der Spannungsflanke verwendet wird;
einen analogen Komparator (120), der dazu ausgelegt ist, eine Spannung, die entweder eine Referenzspannung oder eine Eingangsspannung ist, mit einer Spannungsausgabe von dem Spannungsflankengenerator zu vergleichen;
ein erstes Register (135), das dazu ausgelegt ist, eine erste Zählung basierend darauf zu speichern, dass die Referenzspannung (Vref) in den analogen Komparator eingegeben wird, wobei die erste Zählung unter Verwendung eines Zählers (130) bestimmt wird, der dazu ausgelegt ist, das Zählen basierend auf einem Beginn der Spannungsflanke zu beginnen;
ein zweites Register (140), das so ausgelegt ist, dass es unter Verwendung des Zählers (130) einen zweiten Zählwert speichert, der auf der in den analogen Komparator eingegebenen Eingangsspannung basiert, wobei die Eingangsspannung die Spannung ist, die vom ADC in einen digitalen Wert umgewandelt werden soll; und
einen Digital-Analog-Wandler (DAC) (160), der dazu ausgelegt ist, ein Flankenabgleichsignal basierend auf der Spannungsflankenausgabe durch den Spannungsflankengenerator, der ersten Zählung und einem Zählungsziel, das mit der Spannungsreferenz assoziiert ist, zu erzeugen, wobei der DAC (160) einen digitalen Integrator (162), einen digitalen Komparator (166), eine Impulsschaltung (168), einen Kondensator (170), einen Abtast- und Halteschalter (172) beinhaltet, und einen Puffer (164), wobei der digitale Integrator (162) dazu ausgelegt ist, die Differenz zwischen der ersten Zählung des ersten Registers und dem Zählziel zu summieren, um einen Integratorwert zu erzeugen, wobei ein Ausgang des digitalen Integrators (162) mit dem digitalen Komparator 166 verbunden ist, der dazu ausgelegt ist, auszulösen, wenn ein Zählerwert des Zählers (130) den Integratorwert erreicht, und wobei die Impulsschaltung (168) dazu ausgelegt ist, einen Impuls basierend auf einer Flanke des Ausgangs des digitalen Komparators (166) zu erzeugen, wobei der Abtast- und Halteschalter (172) dazu ausgelegt ist, basierend auf dem Impuls zu schließen und die Spannungsflanke zum Erzeugen des Flankenabgleichsignals abzutasten,
wobei der variable Strom in dem Spannungsflankengenerator auf dem Flankenabgleichsignal basiert.

2. ADC (200) nach Anspruch 1, wobei der Spannungsflankengenerator Folgendes beinhaltet:
eine Konstantstromquelle (210), die so ausgelegt ist, dass sie den konstanten Strom erzeugt; und
einen Spannungs-Strom-(VI)-Wandler (150), der dazu ausgelegt ist, das Flankenabgleichsignal in den variablen Strom umzuwandeln.

3. ADC (200) nach Anspruch 1, wobei der Spannungsflankengenerator einen Spannungs-Strom-(VI)-Wandler (150) beinhaltet, der dazu ausgelegt ist, das Flankenabgleichsignal in den variablen Strom umzuwandeln,
wobei der VI-Wandler (150) den konstanten Strom erzeugt und den konstanten Strom mit dem variablen Strom kombiniert, um einen Flankenstrom zu erzeugen, der zum Erzeugen der Spannungsflanke verwendet wird.

4. ADC (200) nach einem der vorhergehenden Ansprüche, wobei der Puffer (164) ein analoger Puffer ist, der zwischen den Ausgang des Spannungsflankengenerators und den Abtast- und Halteschalter geschaltet ist.

5. ADC (200) nach einem der vorhergehenden Ansprüche, der ferner Folgendes umfasst:
einen Schalter (125) mit einem Ausgang, der mit dem analogen Komparator (120) verbunden ist, und einem ersten Eingang, der zum Empfangen der Referenzspannung (Vref) konfiguriert ist, und einem zweiten Eingang, der zum Empfangen der Eingangsspannung konfiguriert ist; und
einen Controller, der dazu ausgelegt ist, den Schalter zwischen dem ersten Eingang und dem zweiten Eingang zu betätigen.

6. ADC (200) nach Anspruch 5, wobei der Controller ferner dazu ausgelegt ist, zu bestimmen, wann sich die Ausgabe des DAC (160) abgesetzt hat.

7. ADC (200) nach Anspruch 5 oder 6, wobei der Spannungsflankengenerator ferner einen Flankenschalter (110) beinhaltet und wobei der Controller ferner dazu ausgelegt ist, den Flankenschalter (100) zu steuern, um die Spannungsflanke zu erzeugen.

8. ADC (200) nach einem der vorhergehenden Ansprüche, wobei die zweite Zählung einen digitalen Wert angibt, der der Eingangsspannung entspricht.

9. Verfahren zur Umwandlung einer analogen Spannung in einen digitalen Wert unter Verwendung eines selbstkalibrierenden Analog-Digital-Wandlers (ADC) mit einer einzelnen Flanke, das Folgendes umfasst:
Erzeugen einer Spannungsflanke basierend auf einem konstanten Strom und einem variablen Strom, wobei der konstante Strom und der variable Strom kombiniert werden, um einen Flankenstrom zu erzeugen, der verwendet wird, um die Spannungsflanke zu erzeugen;
Vergleichen einer Referenzspannung mit der Spannungsausgabe aus der erzeugten Spannungsflanke und Speichern einer ersten Zählung basierend auf der Referenzspannung, wobei die erste Zählung unter Verwendung eines Zählers (130) bestimmt wird, der dazu ausgelegt ist, das Zählen basierend auf einem Anfang der Spannungsflanke zu beginnen;
Vergleichen einer Eingangsspannung mit der Spannungsausgabe aus der erzeugten Spannungsflanke und Speichern einer zweiten Zählung basierend auf der Eingangsspannung, wobei die zweite Zählung unter Verwendung des Zählers (130) bestimmt wird; und
Erzeugen eines Flankenabgleichsignals basierend auf der Spannungsflanke, der ersten Zählung und einem Zählziel, das mit der Spannungsreferenz assoziiert ist, wobei das Erzeugen eines Flankenabgleichsignals ferner Folgendes beinhaltet: Integrieren einer Differenz zwischen der ersten Zählung und einem Zählziel, um eine integrierte Differenz zu erzeugen; Vergleichen der integrierten Differenz mit einem Taktwert, der eine Zeit ab einem Anfang der Spannungsflanke angibt; und Abtasten und Halten einer gepufferten erzeugten Spannungsflanke, um das Flankenabgleichsignal zu erzeugen, wenn der Taktwert gleich der integrierten Differenz ist;
wobei das Flankenabgleichsignal verwendet wird, um den variablen Strom zu erzeugen.

10. Verfahren nach Anspruch 9, wobei das Erzeugen einer Spannungsflanke Folgendes beinhaltet:
Erzeugen des konstanten Stroms;
Spannungsumwandlung des Flankenabgleichsignals in den variablen Strom; und
Umwandeln des Flankenstroms in die Spannungsflanke.

11. Verfahren nach Anspruch 9 oder 10, wobei das Erzeugen einer Spannungsflanke das Betätigen eines Flankenschalters zum Erzeugen der Spannungsflanke beinhaltet.

## Revendications

1. Convertisseur analogique-numérique, ADC, (200) à rampe unique auto-étalonnant comprenant :
un générateur de rampe de tension configuré pour générer, et délivrer en sortie, une rampe de tension sur la base d'un courant fixe et d'un courant variable, le courant fixe et le courant variable étant combinés pour produire un courant de rampe utilisé pour générer la rampe de tension ;
un comparateur analogique (120) configuré pour comparer une tension étant soit une tension de référence, soit une tension d'entrée, à une tension de sortie du générateur de rampe de tension ;
un premier registre (135) configuré pour stocker un premier comptage sur la base de la tension de référence (Vref) étant appliquée en entrée dans le comparateur analogique, le premier comptage étant déterminé au moyen d'un compteur (130) configuré pour commencer un comptage sur la base du début de la rampe de tension ;
un deuxième registre (140), configuré pour stocker un deuxième comptage, au moyen du compteur (130), sur la base de la tension d'entrée étant appliquée en entrée dans le comparateur analogique, où la tension d'entrée est la tension à convertir en une valeur numérique par l'ADC ; et
un convertisseur numérique-analogique, DAC, (160) configuré pour produire un signal d'ajustement de rampe sur la base de la sortie de rampe de tension par le générateur de rampe de tension, du premier comptage et d'une cible de comptage associée à la référence de tension, où le DAC (160) comprend un intégrateur numérique (162), un comparateur numérique (166), un circuit impulsionnel (168), un condensateur (170), un commutateur d'échantillonnage et de maintien (172) et un tampon (164), où l'intégrateur numérique (162) est configuré pour sommer la différence entre le premier comptage du premier registre et la cible de comptage pour générer une valeur d'intégrateur, où une sortie de l'intégrateur numérique (162) est connectée au comparateur numérique (166), qui est configuré pour déclencher lorsqu'une valeur de compteur du compteur (130) atteint la valeur d'intégrateur, et où le circuit impulsionnel (168) est configuré pour créer une impulsion sur la base d'un front de la sortie du comparateur numérique (166), où le commutateur d'échantillonnage et de maintien (172) est configuré pour se fermer sur la base de l'impulsion et pour échantillonner la rampe de tension pour ladite production du signal d'ajustement de rampe,
où le courant variable dans le générateur de rampe de tension est basé sur le signal d'ajustement de rampe.

2. ADC (200) selon la revendication 1, dans lequel le générateur de rampe de tension inclut :
une source de courant fixe (210) configurée pour générer le courant fixe ; et
un convertisseur tension-courant, VI, (150) configuré pour convertir le signal d'ajustement de rampe en courant variable.

3. ADC (200) selon la revendication 1, dans lequel le générateur de rampe de tension comprend un convertisseur de tension-courant, VI, (150) configuré pour convertir le signal d'ajustement de rampe en courant variable,
où le convertisseur VI (150) produit le courant fixe et combine le courant fixe avec le courant variable pour produire un courant de rampe utilisé pour générer la rampe de tension.

4. ADC (200) selon l'une quelconque des revendications précédentes, dans lequel le tampon (164) est un tampon analogique connecté entre la sortie du générateur de rampe de tension et le commutateur d'échantillonnage et de maintien.

5. ADC (200) selon l'une quelconque des revendications précédentes, comprenant en outre :
un commutateur (125) ayant une sortie connectée au comparateur analogique (120) et une première entrée configurée pour recevoir la tension de référence (Vref) et une deuxième entrée configurée pour recevoir la tension d'entrée ; et
contrôleur configuré pour actionner le commutateur entre la première entrée et la deuxième entrée.

6. ADC (200) selon la revendication 5, dans lequel le contrôleur est en outre configuré pour déterminer quand la sortie de l'ADC (160) s'est stabilisée.

7. ADC (200) selon les revendications 5 ou 6, dans lequel le générateur de rampe de tension comprend en outre un commutateur de rampe (110) et dans lequel le contrôleur est en outre configuré pour commander le commutateur de rampe (100) afin de générer la rampe de tension.

8. ADC (200) selon l'une quelconque des revendications précédentes, dans lequel le deuxième compteur indique une valeur numérique correspondant à la tension d'entrée.

9. Procédé de conversion d'une tension analogique en une valeur numérique à l'aide du convertisseur analogique-numérique, ADC, à rampe unique auto-étalonnant, le procédé comprenant les étapes suivantes :
générer une rampe de tension sur la base d'un courant fixe et d'un courant variable, le courant fixe et le courant variable étant combinés pour produire un courant de rampe utilisé pour générer la rampe de tension ;
comparer une tension de référence à la tension de sortie de la rampe de tension générée et stocker un premier compte sur la base de la tension de référence, le premier compte étant déterminé à l'aide d'un compteur (130) configuré pour commencer un comptage à partir du début de la rampe de tension ;
comparer une tension d'entrée à la tension de sortie de la rampe de tension générée et stocker un deuxième compte sur la base de la tension d'entrée, ledit deuxième compte étant déterminé à l'aide du compteur (130) ; et
produire un signal d'ajustement de rampe sur la base de la rampe de tension, du premier compte et d'une cible de compte associée à la référence de tension, la production d'un signal d'ajustement de rampe comprenant en outre les étapes suivantes : intégrer une différence entre le premier compte et une cible de compte pour générer une différence intégrée ; comparer la différence intégrée à une valeur d'horloge indicative d'un temps écoulé depuis le début de la rampe de tension ; et échantillonner et
maintenir une rampe de tension générée placée en mémoire tampon pour produire le signal d'ajustement de rampe lorsque la valeur d'horloge est égale à la différence intégrée ;
où le signal d'ajustement de rampe est utilisé pour générer le courant variable.

10. Procédé selon la revendication 9, dans lequel la génération d'une rampe de tension comprend les étapes suivantes :
générer le courant fixe ;
convertir la tension du signal d'ajustement de rampe en courant variable ; et
convertir le courant de rampe en rampe de tension.

11. Procédé selon les revendications 9 ou 10, dans lequel la génération d'une rampe de tension comprend d'actionner un commutateur de rampe pour générer la rampe de tension.
